(19) Europäisches Patentamt
European Patent Office
Office européen des brevets

(11) **EP 3 883 113 A1**

(12) **EUROPEAN PATENT APPLICATION**

(43) Date of publication:
**22.09.2021 Bulletin 2021/38**

(51) Int Cl.:
*H02M 5/458* (2006.01)    *G01R 19/04* (2006.01)
*G01R 27/26* (2006.01)    *G01R 31/64* (2020.01)
*H02M 1/00* (2006.01)

(21) Application number: **20164403.6**

(22) Date of filing: **20.03.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Mitsubishi Electric R & D Centre Europe B.V.
1119 NS Schiphol Rijk (NL)**
Designated Contracting States:
**FR**
• **Mitsubishi Electric Corporation
Tokyo 100-8310 (JP)**
Designated Contracting States:
**AL AT BE BG CH CY CZ DE DK EE ES FI GB GR
HR HU IE IS IT LI LT LU LV MC MK MT NL NO PL
PT RO RS SE SI SK SM TR**

(72) Inventor: **FOUBE, Laurent
35708 RENNES Cedex 7 (FR)**

(74) Representative: **Cabinet Le Guen Maillet
3, impasse de la Vigie
CS 71840
35418 Saint-Malo Cedex (FR)**

(54) **A METHOD FOR ON-LINE MONITORING A DC-BUS CAPACITOR**

(57)    The present invention concerns a method and a device for on-line monitoring a DC-bus capacitor comprised in a three phases power converter, the power converter being connected to a single or three-phase alternating electric power source through a rectifier, the power converter controlling the power provided to a load through an output stage controlled using a pulse width modulation performed at a switching frequency. When the power converter is in a stable operating condition, the present invention:
- determines, at a predetermined sampling frequency, a current value going through the output stage,
- calculates an average value of current going through the output stage over each switching period, and filters the determined average current values,
- measures a low frequency DC-bus voltage across the DC-bus capacitor,
- determines a low frequency current going through the DC-bus capacitor from a derivative of the low frequency DC-bus voltage,
- estimates the output current of the rectifier and selects the lowest estimated output current in order to adjust the capacitance value of the DC-bus capacitor
- determines an ageing state of the DC-bus capacitor from the adjusted capacitance value.

Fig. 3

## Description

TECHNICAL FIELD

The present invention relates generally to a method and a system for on-line monitoring a DC-bus capacitor that is included in a power converter.

RELATED ART

In the field of Power Electronics, DC-bus capacitors are known as vulnerable components especially because usually electrolytic capacitors are used for that function. Their failure leads to out-of-service condition for the entire power converter.

DC-bus capacitors are often the most limiting factor for long-life products. This is the reason why we observe an increased interest in Condition Monitoring technologies, thus permitting a timely replacement of these components, while disturbance on the service rendered by the equipment is minimised.

Solutions have been proposed to detect ageing of DC-bus capacitors. Usually the ageing detection is made by monitoring the variation of some parameters of the DC-bus capacitor. For example, a reduction of the DC-bus capacitance value may be used to detect the end of life of the DC-bus capacitor.

Capacitor ageing detection methods that operate during the operation of the power converter and that do not use capacitor current sensors are usually not accurate enough and require special mode of operation to be applicable like, for example, regenerative operation.

Some methods require relatively high sampling rate and/or complex processing that also tend to increase the cost of monitoring system due to the need for higher processing capabilities.

The state of the art methods are thus either costly or require the injection of disturbance, source of vibrations and torque ripple as a side effect.

SUMMARY OF THE INVENTION

The present invention aims at providing a non-intrusive DC-bus capacitor condition monitoring system that is included in a power converter which is low cost, resilient to disturbances, has repeatable performance and does not need to impose a special mode of operation to the power converter.

To that end, the present invention concerns a method for on-line monitoring a DC-bus capacitor comprised in a three phases power converter, the power converter being connected to a single or three-phase alternating electric power source through a rectifier, the power converter controlling the power provided to a load through an output stage controlled using a pulse width modulation performed at a switching frequency, the switching period being the period of the switching frequency, characterized in that the method comprises the step of detecting if the power converter is in a stable operating condition and if the power converter is in a stable operating condition, the method further comprises the steps of:

- obtaining switching information of the output stage,
- obtaining, for each phase of the load, a current value of the phase at a predetermined sampling frequency, the predetermined sampling frequency being equal to the switching frequency or the double of the switching frequency,
- determining, at the predetermined sampling frequency, a current value going through the output stage using switching information and measured current values,
- calculating an average value of current going through the output stage over each switching period,
- filtering the determined average current values over plural switching periods,
- measuring a low frequency DC-bus voltage across the DC-bus capacitor at the predetermined sampling frequency,
- determining a low frequency current going through the DC-bus capacitor from a derivative of the low frequency DC-bus voltage across the DC-bus capacitor,
- estimating the output current of the rectifier at the sampling frequency and memorizing each estimated current,
- selecting the lowest memorized value of the current within a time period which is equal to the period of twice the frequency of the alternating electric power source multiplied by the number of phases of the alternating electric power source,
- adjusting the capacitance value of the DC-bus capacitor by using the selected lowest memorized value,
- determining an ageing state of the DC-bus capacitor from the updated capacitance value of the DC-bus capacitor.

The present invention concerns also a device for on-line monitoring a DC-bus capacitor comprised in three phases power converter, the power converter being connected to a single or three-phase alternating electric power source through a rectifier, the power converter controlling the power provided to a load through an output stage controlled using a pulse width modulation performed at a switching frequency, the switching period being the period of the switching frequency, characterized in that the device comprises means for detecting if the power converter is in a stable operating condition and if the power converter is in a stable operating condition, the device comprises means for activating:

- means for obtaining switching information of the output stage,
- means for obtaining, for each phase of the load, a current value of the phase at a predetermined sampling frequency, the predetermined sampling frequency being equal to the switching frequency or the double of the switching frequency,

- means for determining, at the predetermined sampling frequency, a current value going through the output stage using switching information and measured current values,
- means for calculating an average value of current going through the output stage over each switching period,
- means for filtering the determined average current values over plural switching periods,
- means for measuring a low frequency DC-bus voltage across the DC-bus capacitor at the predetermined sampling frequency,
- means for determining a low frequency current going through the DC-bus capacitor from a derivative of the low frequency DC-bus voltage across the DC-bus capacitor,
- means for estimating the output current of the rectifier at the sampling frequency and memorizing each estimated current,
- means for selecting the lowest memorized value of the current within a time period which is equal to the period of twice the frequency of the alternating electric power source multiplied by the number of phases of the alternating electric power source,
- means for adjusting the capacitance value of the DC-bus capacitor by using the selected lowest memorized value,
- means for determining an ageing state of the DC-bus capacitor from the updated capacitance value of the DC-bus capacitor.

Thus, by using information from normally available sensors and control information it is possible to assess the ageing state of the DC-bus capacitor allowing a timely replacement when the DC-bus capacitor has reached end of life. As the present invention can be implemented in software, cost is reduced.

According to a particular feature, the power converter is in the stable operating condition when the temperature of the DC-Bus capacitor is stabilized and the power converter is in steady state operation, i.e. constant operating parameters.

Thus, the estimation of capacitance value of the DC-Bus capacitor under these conditions is meaningful (otherwise, since the capacitance value is a temperature sensitive parameter, the estimation would not be reliable, i.e. measured in transient state, and would not allow ageing assessment with respect to initial value).

According to a particular feature, the output stage is controlled using a space vector modulation.

Thus, the states of the gates of the output stage can be determined. They allow to calculate the inverter current by using the values of output phase currents. Other pulse width modulation (PWM) methods are applicable as well, such as for instance SPWM (sinusoidal PWM) and two-phase PWM modulation.

According to a particular feature, the low frequency DC-bus voltage across the DC-bus capacitor is measured outside switching areas.

Thus, this allows to capture only the low frequency contents of the DC bus voltage. The high frequency content due to the switching of the output stage is considered here as a disturbance and can be strongly alleviated by performing a synchronous sampling at either the switching frequency or at twice the sampling frequency (typically synchronous with the bottom an/or top of the carrier frequency used to generate the PWM signals). No switching occurs at those particular sampling positions.

According to a particular feature, the low frequency current going through the DC-bus capacitor *Icap_LF* is determined using the following equation:

$$Icap\_LF = \mathrm{Cest}\frac{d(\mathrm{Vcap\_LF})}{dt}$$

where Vcap_LF is the low frequency DC-bus voltage across the DC-bus capacitor and Cest is, at a first iteration, a predetermined capacitance value of the DC-bus capacitor and is the updated capacitance value of the DC-bus capacitor at following iterations.

Thus, a closed-loop system is implemented where the value of Cest progresses to a stable, precise value, that tracks the actual capacitance value of DC-bus capacitor.

According to a particular feature, the method further comprises the step of checking if the updated capacitance value of the DC-bus capacitor is valid.

Thus, it enables the ageing assessment of the DC-bus capacitor.

According to a particular feature, the updated capacitance value of the DC-bus capacitor is not valid if the updated capacitance value of the DC-bus capacitor is higher than a previous updated capacitance value of the DC-bus capacitor estimated at a same temperature.

Thus, this enables to reject wrong estimation of the capacitance value that may be caused by some measurements corrupted by noise.

According to a particular feature, the method further comprises the step of forming a reference table that comprises plural capacitances estimations of the DC-bus capacitor determined at different temperatures during early life of the DC-bus capacitor in a self calibration.

Thus, the present invention enables ageing assessment at different temperatures since the capacitance is a temperature sensitive parameter. The reference table constructed by the system itself allows a better ageing assessment since reference values are actual state of the DC capacitor in early state.

According to a particular feature, the updated capacitance value of the DC-bus capacitor is valid if the rectifier is not conducting.

BRIEF DESCRIPTION OF THE DRAWINGS

The characteristics of the invention will emerge more clearly from a reading of the following description of example embodiments, the said description being produced with reference to the accompanying drawings, among which:

Fig. 1 represents an example of an architecture of a power converter that is, in the example of Fig. 1, a three-phase inverter that includes a DC-bus capacitor condition monitoring system according to the present invention;

Fig. 2 represents the architecture of a processing unit of the DC-bus capacitor condition monitoring system according to the present invention;

Fig. 3 represents an example of an algorithm for monitoring the condition of a DC-bus capacitor of a power converter according to the present invention;

Fig. 4 represents an example of an algorithm for adjusting the capacitance value of the DC-bus capacitor according to the present invention;

Fig. 5 represents signals of the three-phase inverter that are used according to the present invention;

Figs. 6 represent an example of algorithms for determining if the diode front end rectifier 110 is or not conducting.

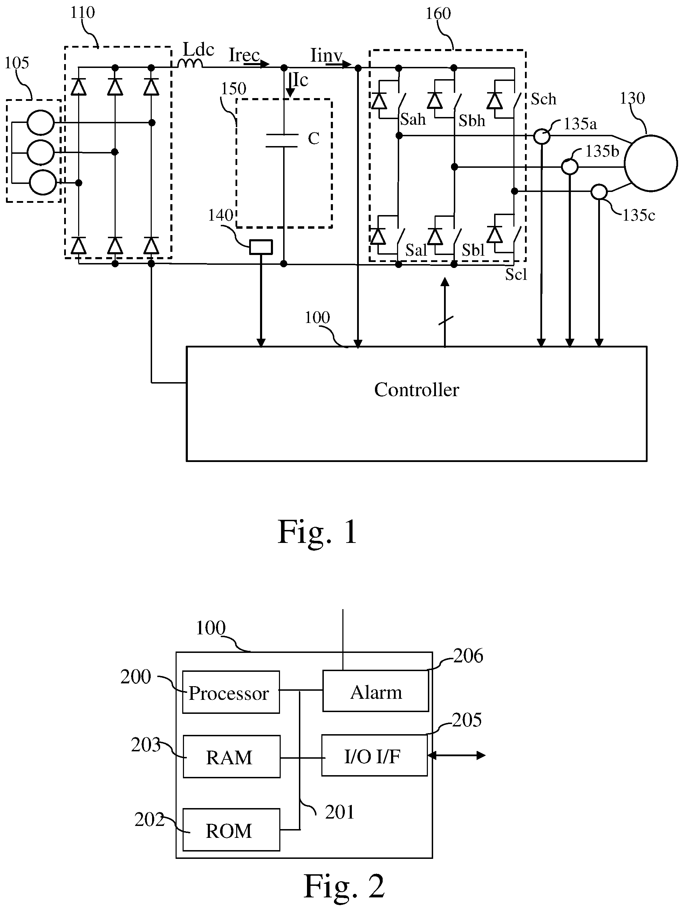

**Fig. 1** represents an example of an architecture of a power converter that is, in the example of Fig. 1, a three-phase inverter that includes a DC-bus capacitor condition monitoring system according to the present invention.

The power converter is mainly composed of an output stage that is, in the example of Fig. 1, a three-phase inverter 160, a DC-bus capacitor 150, a diode front end rectifier 110, followed possibly by a DC reactor Ldc and a processing unit 100.

The three-phase inverter may be used for motor drive application, with a three-phase diode rectifier front end. It has to be noted here that the diode front end rectifier may be a single phase rectifier connected to a single phase AC source.

The DC-bus capacitor 150 may be composed of plural capacitors, thus forming a capacitor bank.

The power converter may receive single phase or three-phase alternating electric (AC) power 105 and drives a load 130 that is, for example, a three-phase motor.

Each phase of the load 130 comprises one current sensor noted 135a, 135b and 135c. In a variant, only two phases of the load 130 comprise one current sensor, the current of the other phase of the load being determined from the values provided by the two current sensors.

The power converter may comprise a temperature sensor 140 that senses the temperature of the DC-bus capacitor 150. Alternatively, the temperature of capacitor may also be estimated considering the ambient temperature within the power converter and its operating point for instance, or from a known measured temperature in the volume of the converter.

The temperature sensor 140 may sense the surface temperature of the DC-bus capacitor 150 or may be tightly thermally coupled to one of the terminals of the DC-bus capacitor 150 to better reflect the internal temperature of the DC-bus capacitor 150.

According to the invention, the capacitance value of the DC-bus capacitor 150 is monitored.

The processing unit 100 controls the switches of the three-phase inverter 160, for example using a space vector modulation as pulse width modulation method and monitors the condition of the DC-bus capacitor. The three-phase inverter 160 converts a DC-bus voltage into three alternating output voltages, via a series of switches Sah, Sal, Sbh, Sbl, Sch and Scl, forming three output legs which are connected to the three-phase load 130.

According to the invention, the processing unit 100:

- obtains switching information of the output stage,
- obtains, for each phase of the load, a current value of the phase at a predetermined sampling frequency, the predetermined sampling frequency being equal to the switching frequency or the double of the switching frequency,
- determines, at the predetermined sampling frequency, a current value going through the output stage using switching information and measured current values,
- calculating an average value of current going through the output stage over each switching period,
- filters the determined average current values over plural switching periods,
- measures a low frequency DC-bus voltage across the DC-bus capacitor at the predetermined sampling frequency,
- determines a low frequency current going through the DC-bus capacitor from a derivative of the low frequency DC-bus voltage across the DC-bus capacitor,
- estimates the output current of the rectifier at the sampling frequency and memorizing each estimated current,
- selects the lowest memorized value of the current within a time period which is equal to the period of twice the frequency of the alternating electric power source multiplied by the number of phases of the alternating electric power source,
- adjusts the capacitance value of the DC-bus capacitor by using the selected lowest memorized value,
- determines an ageing state of the DC-bus capacitor from the updated capacitance value of the DC-bus capacitor.

**Fig. 2** represents the architecture of a processing unit of the DC-bus capacitor condition monitoring system according to the present invention.

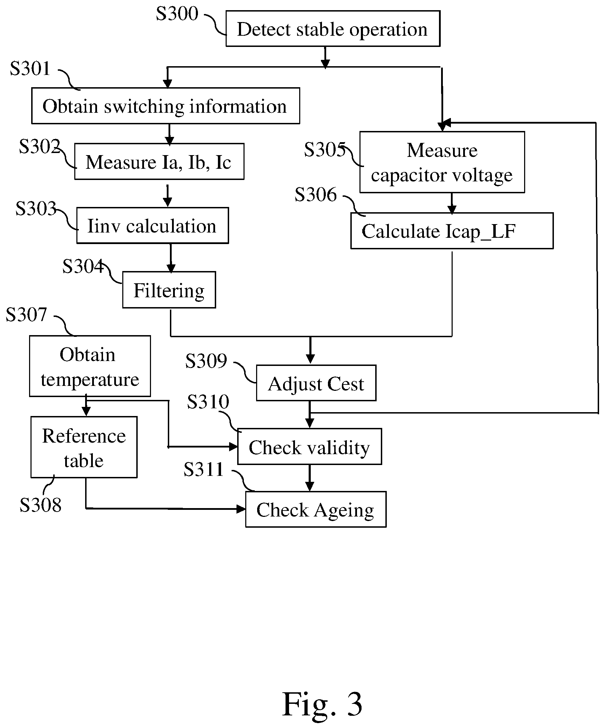

The processing unit 100 has, for example, an architecture based on components connected together by a bus 201 and a processor 200 controlled by a program as disclosed in Figs. 3 and 4, 6a and 6b.

The bus 201 links the processor 200 to a read only memory ROM 202, a random access memory RAM 203, an input output I/O IF interface 205 and an alarm interface 206. The memory 203 contains registers intended to receive variables and the instructions of the program related to the algorithm as disclosed in Figs. 3, 4, 6a and 6b.

The processor 200 receives through the input output I/O IF 205 sensed temperature 140, current values sensed by the sensors 135a, 135b, 135c, the DC-bus capacitor voltage and transfers command signals to the three-phase inverter 160. The input output I/O IF includes an analogue to digital converter.

The processor 200, upon detection of the end of life of the DC-bus capacitor 150, commands the alarm module 206 which is for example a LED or an alarm signal that notifies a maintenance request.

The read-only memory, or possibly a Flash memory 202, contains instructions of the programs related to the algorithm as disclosed in Figs. 3, 4, 6a and 6b, when the processing unit 100 is powered on, are loaded to the random access memory 203. Alternatively, the program may also be executed directly from the ROM memory 202.

The control performed by the processing unit 100 may be implemented in software by execution of a set of instructions or program by a programmable computing machine, such as a PC (*Personal Computer*), a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*).

In other words, the processing unit 100 includes circuitry, or a device including circuitry, causing the processing unit 100 to perform the program related to the algorithm as disclosed in Figs. 3, 4, 6a and 6b.

**Fig. 3** represents an example of an algorithm for monitoring the condition of a DC-bus capacitor of a power converter according to the present invention.

The present algorithm is disclosed in an example wherein it is executed by the processor 200 of the processing unit 100 when the power converter is a three phase inverter and, for example, at a frequency Fsw or 2*Fsw where Fsw is the switching frequency of the power converter.

At step S300, the processor 200 determines if the power converter is in a stable operating condition. A stable operating condition is realized when the temperature of the DC-bus capacitor 150 is stabilized and the power converter is in steady state operation, i.e. constant operating parameters. In other words, the power converter has been operating at a constant operating point for some time.

Detecting a stable operating condition is performed by detecting unchanged operating condition during a time interval that is superior to the thermal time constant of the monitored DC-bus capacitor 150 as the capacitance value of the DC-bus capacitor 150 is sensitive to temperature.

Ambient temperature within converter's enclosure is not expected to change rapidly, however internal self-heating of capacitor might be created by a sudden increase of output power for instance, causing a stronger current ripple. The time constant can be typically in a range extending from a few minutes up to ten of minutes depending on size of the DC-bus capacitor 150. No stable operation is detected during a transient time following a large change of operating point.

The operating condition is defined by at least the DC-bus capacitor temperature, the average of the calculated output current Iinv and the average value of the DC bus voltage. The averaged output power can indeed be calculated by using the average of the calculated output current Iinv and the average value of the DC bus voltage. Other variables such as the modulation index (or modulation depth) may also be considered to define the operating point.

If the load 130 is a motor, other higher-level operating conditions, such as the motor speed, the motor torque, can also be considered as valuable operating conditions.

Any significant change on variables considered to define the "operating condition" triggers some waiting time in order to reach a thermal stabilization. In other words, the system waits typically for several minutes of steady state operation before performing estimations.

When the processor 200 determines that the power converter is in a stable operating condition, the processor 200 moves to steps S301 and S305.

At step S301, the processor 200 obtains the switching information of the three-phase inverter 160.

For example, the three phase inverter 160 is controlled using a space vector modulation used as a pulse width modulation method of the three-phase inverter 160.

Space vector modulation (SVM) is an algorithm for the control of pulse width modulation (PWM). This method is commonly used for motor drive applications to control the variable speed of a three-phase AC powered motor. The basic idea of the method is the synthesis of a rotating reference vector. During its rotation, the reference vector successively traverses the six sectors. The three-phase power inverter generates a complete low frequency electric period of each output phase voltage for each full rotation of the reference vector. A new reference vector is calculated every switching interval, typically at several kHz. The step S301 is thus performed once per switching interval.

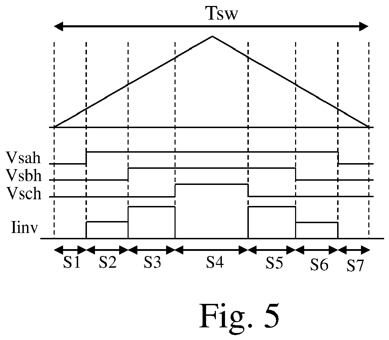

Each synthesis of the reference vector leads thus to the generation of a particular PWM pattern for the three-legs of inverter such as described on Fig. 5. Duration of activation of the different gate signals directly results from the synthesis process of the voltage reference vector which in turn depends on the control of the three-phase inverter.

**Fig. 5** represents signals of the three-phase inverter that are used according to the present invention.

Fig. 5 represents the variations of the calculated three phase inverter current Iinv in a time period Tsw of the space vector modulation.

The signals Vsah, Vsbh and Vsch are the gate signals provided to the switches Sah, Sbh and Sch. The transitions of signals Vsah, Vsbh and Vsch define different regions or segments within the switching interval Tsw.

The calculated three-phase inverter current Iinv varies between each segment S 1 to S7.

At step S302, the processor 200 obtains current values sensed by the sensors 135a, 135b, 135c.

At step S303, the processor 200 determines the current Iinv going through the output stage 160 of the three-phase inverter. The current Iinv is calculated using switching information and measurements of power converter's output phases currents provided by sensors 135a to 135c. Due to the relatively low frequency of output currents, the sensed currents are typically captured at the switching frequency Fsw of the three-phase inverter 160 since their variation is very limited and can be considered as constant during a pulse width modulation switching period of duration Tsw=1/Fsw. For example, Fsw is equal to 5Khz.

It has to be noted here that the sensed currents may be sampled at 2*Fsw in case of stronger variation during switching period.

Iinv is calculated every switching period by using the values of the modulation signals that are calculated by the controller 100. The values of the modulation signals allow to determine the switching information, i.e. the states of the differents gates (thus the states of the corresponding switches) within the switching period.

The determination of the value of the current Iinv within each time interval can be calculated as the sum of the currents flowing in the different switches Sah, Sbh and Sch when the switches are respectively conducting.

At step S304, the processor 200 filters the determined values over plural switching periods. The filtered Iinv value Iinv_dc may be performed by averaging the determined currents taking into account the durations of the times intervals S1 to S7 that may possibly be completed using a recursive digital filter or a moving average filter.

At step S305, the processor 200 obtains the DC-bus voltage value , i.e. the voltage across the DC-bus capacitor 150.

More precisely, the DC-bus voltage is divided by a voltage divider in order to adjust the voltage at the input of the analogue to digital converter and filtered by a low pass filter used for anti-aliasing and noise reduction purpose. The DC-bus voltage is measured, outside switching areas, only low frequency content of the DC-bus voltage is measured. The DC-bus voltage is preferably measured at 2*Fsw in order to improve the estimation of its derivative.

At step S306, the processor 200 determines the low frequency current *Icap_LF* going through the DC-bus capacitor.

The low frequency current going through the DC-bus capacitor 150 is equal to derivative of low frequency capacitor voltage and determined using the following equation:

$$Icap\_LF = \mathrm{Cest}\frac{\mathrm{d(Vcap\_LF)}}{\mathrm{dt}}$$

At the first iteration of the present algorithm, the capacitance value of the DC-bus capacitor 150 Cest is predetermined, for example equal to the theorical capacitance value of the DC-bus capacitor 150, or is equal to the capacitance value measured before installation within the power converter. Vcap_LF is the low frequency voltage across the DC-bus capacitor 150.

At step S309, the processor 200 determines the value of the capacitance Cest.

As the DC-bus capacitor is ageing, the capacitance value decreases over time.

The principle of the determination of Cest is based on the fact that the rectifier current is always positive or null and becomes null during some time at every low frequency period of the DC bus disturbance created by the rectifier, the low frequency period beeing equal to 1/300 Hz typically, which is six times the input frequency of a fin=50 Hz AC signal for a three-phase rectifier or 1/100 Hz for a single phase rectifier.

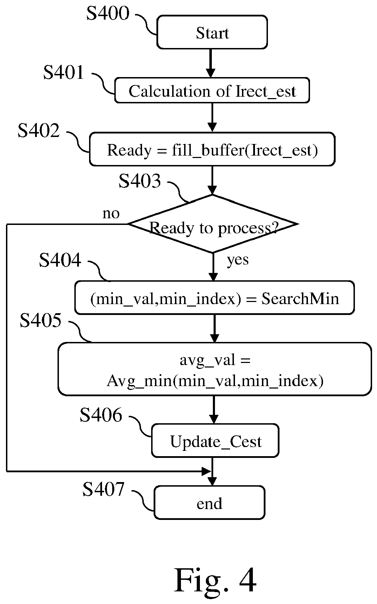

The determination of the capacitance value Cest is disclosed in Fig. 4.

**Fig. 4** represents an example of an algorithm for adjusting the DC-bus capacitor capacitance value according to the present invention.

The present algorithm is disclosed in an example wherein it is executed by the processor 200 of the processing unit 100 every low frequency period which is for example equal to 1/300 Hz.

At step S400, the processor 200 starts the algorithm.

At step S401, the processor 200 obtains an estimate of the current rectifier as Irect_est = Iinv_dc + Icap_LF, for example at the predetermined sampling frequency which is equal to the switching frequency or the double of the switching frequency.

At step S402, the processor 200 memorizes the obtained estimate of the current rectifier in a buffer.

For example, the buffer has a size sufficient to store a complete low frequency period (1/(6*fin)) of estimated rectifier current, which is in that example equal to 34 estimates in case of Fsw=5KHz, fin=50Hz, and with a sampling frequency = 2*Fsw.

At the same step, the processor 200 reads a variable noted Ready that indicates if the buffer is full.

At step S403, the processor 200 checks if the variable Ready indicates that the buffer is full. If the buffer is full, the processor 200 moves to step S404, otherwise the processor 200 moves to step S407.

At step S404, the processor 200 selects the mininum value stored in the buffer together with the index of the selected value within the buffer.

At step S405, the processor 200 averages the minimum value by considering a few, for example the two neighbouring, values in buffer. The average minimum value is noted avg_val.

At step S406, the processor 200 updates the capacitance value Cest of the DC-bus capacitor 150.

For example, the processor 200 calculates an error noted err as:

err = avg_val - bias, where bias is a constant typically comprised between -0.2 and 0.

It has to be noted here that the variable bias is an optional small negative value that can be used to further improve the accuracy of estimation of Cest. If bias is set to 0, the value of Cest tends to be slightly underestimated with respect to actual capacitance.

The processor 200 calculates the capacitance value Cest of the DC-bus capacitor 150 as Cest = Cest + err*Kc where Kc is a variable that allows to adjust the rate of convergence to the desired value. For example, Kc is equal to 20. $10^{-6}$.

After that, the processor 200 ends the algorithm disclosed in Fig. 4 and returns to step S310 of Fig. 3.

At step S310, the processor 200 checks if the updated capacitance value of the DC-bus capacitor 150 value is valid.

According to a first mode of realization, if the diode front end rectifier 110 is conducting, the updated capacitance value of the DC-bus capacitor 150 is overestimated. As the capacitance value of the DC-bus capacitor 150 must necessarily decrease with ageing, an estimation higher than previous last known estimation at same temperature is thus considered invalid and discarded since it can only be inferior or equal to this value. Otherwise, last known estimation is updated with newly estimated Cest.

According to a second mode of realization, the processor 200, in order to check if the updated capacitance value of the DC-bus capacitor 150 is valid, determines if the diode front end rectifier 110 is not conducting.

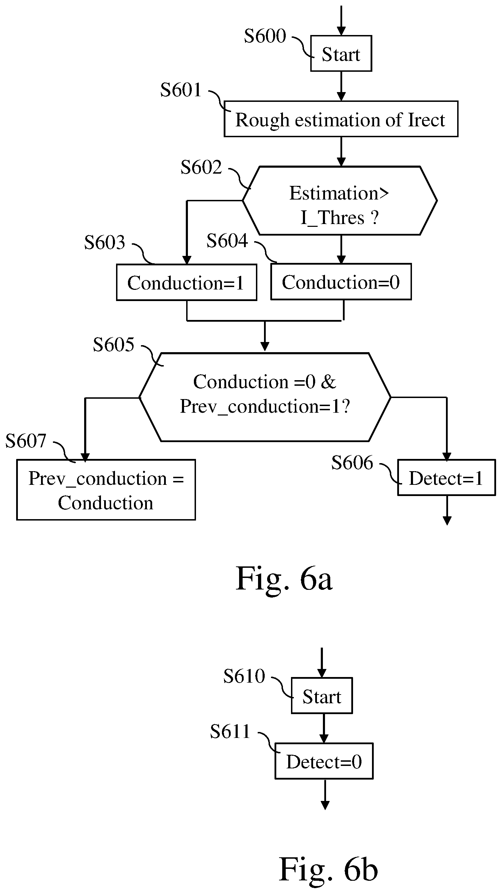

For that, the processor 200 executes the algorithms disclosed in reference to Figs. 6.

**Figs. 6** represent an example of algorithms for determining if the diode front end rectifier 110 is or not conducting.

The algorithm of Fig. 6a is executed at the predetermined sampling frequency which is equal to the switching frequency or the double of the switching frequency and the algorithm of Fig. 6b is executed at the low frequency period of the DC bus disturbance created by the rectifier, the low frequency period beeing equal to 1/300 Hz for a single or three-phase alternating electric power source or 1/100 Hz for a single phase alternating electric power source.

At step S600, the processor 200 starts the execution of the algorithm of Fig. 6a.

At step S601, the processor 200 performs a rough estimation of the diode front end rectifier current as follows:

$$Irect\_rough\_est = C \cdot \frac{dVcap\_LF}{dt} + I_{DC}$$

With $I_{DC}$ = Inv_dc = Avg(Iinv) C is chosen equal for instance to 80 percents of the nominal capacitance value of the DC-bus capacitor. The purpose is to choose a value which is between the minimum possible capacitance value of the DC-bus capacitor in healthy state (considering the manufacturer tolerance) and the expected limit aged value.

At step S602, the processor 200 checks if the rough estimation of the diode front end rectifier current is upper than a predetermined threshold I_Thres.

I_Thres is a small positive value, equal to 0.5 for instance, and enables to adjust the sensibility of discontinuous mode detection. A too small value (very close to 0) might prevent detection of discontinuous conduction under some conditions, while a large value would possibly result in wrongly identifying discontinuous mode conduction. I_threshold enables detection of discontinuous operation when the rough estimation of the diode front end rectifier current does not reach exactly null value during a low frequency period. This typically happens when considered value C is smaller than actual capacitance value. This is the case in early life of the DC-bus capacitor.

If the rough estimation of the diode front end rectifier current is upper than a predetermined threshold, the processor 200 moves to step S603 and sets a variable noted conduction to one.

Otherwise, the processor 200 moves to step S604 and sets the variable conduction to null value.

At step S605, the processor 200 checks if the variable conduction is at one value and if the variable conduction was at null value at previous execution of the present algorithm.

If the variable conduction is at one value and if the variable conduction was at null value at previous execution of the present algorithm, the processor 200 moves to step S606 and sets a variable noted detect to one, i.e. a non conduction is detected and last known estimation of the DC-bus capacitor capacitance value is updated with newly estimated Cest.

Otherwise, the processor 200 moves to step S607.

At step S607, the processor 200 sets the variable Prev_conduction to the value of the variable Conduction.

After that, the processor 200 interrupts the present algorithm.

At step S610, the processor 200 starts the execution of the algorithm of Fig. 6b.

At step S611, the processor 200 sets the variable detect to null value.

According to a third mode of realization, the processor 200, in order to check if the updated capacitance value of the DC-bus capacitor 150 is valid, checks if the output power Pout is below a limit output power Plim, under which the rectifier is known to operate in discontinuous conduction mode. The output power Pout can be calculated as Pout=Iinv_dc*Vcap_avg, where Vcap_avg is the average of DC bus voltage.

The limit output power Plim can be determined during design of the converter (by simulation or calculation) considering the configuration of converter (presence or not of DC reactor Ldc, and its value). Beyond Plim, the conduction of the rectifier is continuous and does not allow estimation. It is worth noting that in many cases, for instance with large DC bus capacitance value and no DC reactor, the limit power Plim can be larger than power rating of converter thus constantly allowing estimation (conduction of rectifier always discontinuous). The value of Plim might as well be "learned" progressively by the monitoring method itself, the bounds of the interval around the value Plim (initially estimated with a large uncertainty interval) are adjusted each time the estimation is valid or not according to a first mode of implementation, i.e. Plim>Pout when the estimation performed at Pout is considered valid (and consequently, Plim is inferior to Pout if estimation is considered invalid). This would allow to perform estimation only when it is possible (i.e. Pout<Plim), to avoid useless processing.

At step S311, the processor 200 determines the ageing state of the DC-bus capacitor.

For example, the processor 200 determines the variation of estimated capacitance Cest, determined at the temperature measured at step S307 with an initial capacitance value estimation at the same temperature.

For that, the processor 200 determines the initial capacitance value of the DC-bus capacitor at step S308 using a reference table.

The reference table comprises plural capacitances estimations determined at different temperatures during early life of the DC-bus capacitor in a self calibration.

If the estimated capacitance value Cest falls below some limit threshold (that can be possibly temperature dependent), the capacitor is declared aged and a warning is asserted by the monitoring system to alert that replacement must be done. A typical limit threshold can be for instance when the ratio reaches 70% of the initial capacitance value estimation at the same temperature.

The self calibration procedure constructs the reference table of initial capacitance value estimation at different operating temperatures.

The self-calibration procedure is typically executed during the initial early hours or days of operation of the power converter, or following a component replacement after a maintenance operation. The processor 200 estimates the initial healthy state by using the capacitance estimation as disclosed by the present algorithm. During self-calibration, the power converter is expected to operate at different temperatures and operating points that will be again encountered in the future.

At the end of the calibration phase, missing values may typically be interpolated in the table to fill the missing values.

At the end of calibration time, if the calibration procedure has not been successful (no enough estimations obtained for instance), a warning could be delivered to the user to require some modification of operating point for instance, or extend the calibration procedure duration. Otherwise, typical values corresponding to healthy state capacitor might be used as future reference.

In a variant, instead of constructing the reference table, a single estimation of an initial capacitance value estimation is performed at a known temperature.

Knowing the variation law of the capacitance value with temperature, the initial capacitance values at other temperatures may be calculated.

Naturally, many modifications can be made to the embodiments of the invention described above without departing from the scope of the present invention.

**Claims**

1. Method for on-line monitoring a DC-bus capacitor comprised in a three phases power converter, the power converter being connected to a single or three-phase alternating electric power source through a rectifier, the power converter controlling the power provided to a load through an output stage controlled using a pulse width modulation performed at a switching frequency, the switching period being the period of the switching frequency, **characterized in that** the method comprises the step of detecting if the power converter is in a stable operating condition and if the power converter is in a stable operating condition, the method further comprises the steps of:

   - obtaining switching information of the output stage,
   - obtaining, for each phase of the load, a current value of the phase at a predetermined sampling frequency, the predetermined sampling frequency being equal to the switching frequency or the double of the switching frequency,
- determining, at the predetermined sampling frequency, a current value going through the output stage using switching information and measured current values,
- calculating an average value of current going through the output stage over each switching period,
- filtering the determined average current values over plural switching periods,
- measuring a low frequency DC-bus voltage across the DC-bus capacitor at the predetermined sampling frequency,
- determining a low frequency current going through the DC-bus capacitor from a derivative of the low frequency DC-bus voltage across the DC-bus capacitor,
- estimating the output current of the rectifier at the sampling frequency and memorizing each estimated current,
- selecting the lowest memorized value of the current within a time period which is equal to the period of twice the frequency of the alternating electric power source multiplied by the number of phases of the alternating electric power source,
- adjusting the capacitance value of the DC-bus capacitor by using the selected lowest memorized value,
- determining an ageing state of the DC-bus capacitor from the updated capacitance value of the DC-bus capacitor.

2. The method according to claim 1, **characterized in that** the power converter is in the stable operating condition when the temperature of the DC-bus capacitor is stabilized and the power converter is in steady state operation.

3. The method according to claim 1 or 2, **characterized in that** the output stage is controlled using a space vector modulation.

4. The method according to any of the claims 1 to 3, **characterized in that** the low frequency DC-bus voltage across the DC-bus capacitor is measured outside switching areas.

5. The method according to any of the claims 1 to 4, **characterized in that** the low frequency current going through the DC-bus capacitor *Icap_LF* is determined using the following equation:

$$Icap\_LF = \mathrm{Cest}\frac{\mathrm{d(Vcap\_LF)}}{\mathrm{dt}}$$

where Vcap_LF is the low frequency DC-bus voltage across the DC-bus capacitor and Cest is, at a first iteration, a predetermined capacitance value of the DC-bus capacitor and is the updated capacitance value of DC-bus capacitor at following iterations.

6. The method according to any of the claims 1 to 5, **characterized in that** the method further comprises the step of checking if the updated capacitance value of the DC-bus capacitor is valid.

7. The method according to claim 6, **characterized in that** the updated capacitance value of the DC-bus capacitor is not valid if the updated capacitance value of the DC-bus capacitor is higher than a previous updated capacitance value of the DC-bus capacitor estimated at a same temperature.

8. The method according to claim 7, **characterized in that** the method further comprises the step of forming a reference table that comprises plural capacitances estimations of the DC-bus capacitor determined at different temperatures during early life of the DC-bus capacitor in a self calibration.

9. The method according to claim 6, **characterized in that** the updated capacitance value of the DC-bus capacitor is valid if the rectifier is not conducting.

10. A device for on-line monitoring a DC-bus capacitor comprised in three phases power converter, the power converter being connected to a single or three-phase alternating electric power source through a rectifier, the power converter controlling the power provided to a load through an output stage controlled using a pulse width modulation performed at a switching frequency, the switching period being the period of the switching frequency, **characterized in that** the device comprises means for detecting if the power converter is in a stable operating condition and if the power converter is in a stable operating condition, the device comprises means for activating:

- means for obtaining switching information of the output stage,
- means for obtaining, for each phase of the load, a current value of the phase at a predetermined sampling frequency, the predetermined sampling frequency being equal to the switching frequency or the double of the switching frequency,
- means for determining, at the predetermined sampling frequency, a current value going through the output stage using switching information and measured current values,
- means for calculating an average value of current going through the output stage over each switching period,
- means for filtering the determined average current values over plural switching periods,
- means for measuring a low frequency DC-bus voltage across the DC-bus capacitor at the predetermined sampling frequency,
- means for determining a low frequency current going through the DC-bus capacitor from a derivative of the low frequency DC-bus voltage across the DC-bus capacitor,
- means for estimating the output current of the rectifier at the sampling frequency and memorizing each estimated current,
- means for selecting the lowest memorized value of the current within a time period which is equal to the period of twice the frequency of the alternating electric power source multiplied by the number of phases of the alternating electric power source,
- means for adjusting the capacitance value of the DC-bus capacitor by using the selected lowest memorized value,
- means for determining an ageing state of the DC-bus capacitor from the updated capacitance value of the DC-bus capacitor.

Fig. 1

Fig. 2

EP 3 883 113 A1

Fig. 3

S400 — Start

S401 — Calculation of Irect_est

S402 — Ready = fill_buffer(Irect_est)

S403 — Ready to process?

no

yes

S404 — (min_val,min_index) = SearchMin

S405 — avg_val = Avg_min(min_val,min_index)

S406 — Update_Cest

S407 — end

# Fig. 4

Fig. 5

S600 — Start

S601 — Rough estimation of Irect

S602 — Estimation> I_Thres ?

S603 — Conduction=1

S604 — Conduction=0

S605 — Conduction =0 & Prev_conduction=1?

S607 — Prev_conduction = Conduction

S606 — Detect=1

## Fig. 6a

S610 — Start

S611 — Detect=0

## Fig. 6b

Europäisches
Patentamt

European
Patent Office

Office européen
des brevets

## EUROPEAN SEARCH REPORT

Application Number

EP 20 16 4403

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 477 314 A1 (MITSUBISHI ELECTRIC R & D CENTRE EUROPE B V [NL] ET AL.) 1 May 2019 (2019-05-01) * paragraph [0007] * * paragraph [0028] - paragraph [0035] * * paragraph [0046] - paragraph [0066] * * paragraph [0085] * * paragraph [0098] - paragraph [0111] * * paragraph [0119] - paragraph [0122] * * figures 1,3-7 * | 1-10 | INV. H02M5/458 G01R19/04 G01R27/26 G01R31/64 H02M1/00 |
| A | US 2017/219441 A1 (DOPPELHAMMER KLAUS [AT] ET AL) 3 August 2017 (2017-08-03) * paragraph [0012] - paragraph [0016] * * paragraph [0047] * * figure 1 * | 1-10 | |
| A | DE 10 2007 016330 A1 (SIEMENS AG [DE]) 16 October 2008 (2008-10-16) * paragraph [0016] - paragraph [0017] * * paragraph [0021] * * paragraph [0073] * | 1-10 | |

TECHNICAL FIELDS
SEARCHED      (IPC)

H02M
G01R

The present search report has been drawn up for all claims

| Place of search | Date of completion of the search | Examiner |
|---|---|---|
| The Hague | 25 August 2020 | Lochhead, Steven |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

 

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 20 16 4403

This annex lists the patent family members relating to the patent documents cited in the above-mentioned European search report.
The members are as contained in the European Patent Office EDP file on
The European Patent Office is in no way liable for these particulars which are merely given for the purpose of information.

25-08-2020

| Patent document cited in search report | | Publication date | Patent family member(s) | | Publication date |
|---|---|---|---|---|---|
| EP 3477314 | A1 | 01-05-2019 | CN | 111247439 A | 05-06-2020 |
| | | | EP | 3477314 A1 | 01-05-2019 |
| | | | US | 2020251982 A1 | 06-08-2020 |
| | | | WO | 2019082535 A1 | 02-05-2019 |
| US 2017219441 | A1 | 03-08-2017 | AT | 518194 A1 | 15-08-2017 |
| | | | CA | 2956510 A1 | 29-07-2017 |
| | | | DK | 3199929 T3 | 03-06-2019 |
| | | | EP | 3199929 A1 | 02-08-2017 |
| | | | US | 2017219441 A1 | 03-08-2017 |
| DE 102007016330 | A1 | 16-10-2008 | NONE | | |

EPO FORM P0459

For more details about this annex : see Official Journal of the European Patent Office, No. 12/82